# FASCICULE DE BREVET EUROPEEN

(11) **EP 1 307 907 B1**
(45) Date de publication et mention de la délivrance du brevet: **16.02.2011**
(21) Numéro de dépôt: 01963039.1
(22) Date de dépôt: 31.07.2001
(51) Int. Cl.: H01L 21/316, C23C 14/10

(54) **PROCEDE DE DEPOT D'UNE COUCHE DE SILICE DOPEE AU FLUOR**
VERFAHREN ZUR ABLAGERUNG EINER FLUORDOTIERTEN SILIZIUMDIOXIDSCHICHT
METHOD FOR DEPOSITING A FLUORINE-DOPED SILICA FILM

(30) Priorité: 01.08.2000 FR 0010149
(43) Date de publication de la demande: 07.05.2003
(73) Titulaire: ESSILOR INTERNATIONAL COMPAGNIE GENERALE D'OPTIQUE, 94227 Charenton cédex (FR)
(72) Inventeur: SCHERER, Karin, F-94100 St Maur (FR); LACAN, Pascale, F-75011 Paris (FR); BOSMANS, Richard, F-94880 Noiseau (FR)
(74) Mandataire: Catherine, Alain
(86) Numéro de dépôt international: PCT/FR2001/002505
(87) Numéro de publication internationale: WO 2002/011195

(56) Documents cités:
- US-A- 5 122 483
- LEE J H ET AL: "Inhomogeneous refractive index of SiO/sub X/F/sub Y/ thin films prepared by ion beam assisted deposition" ELEVENTH INTERNATIONAL CONFERENCE ON SURFACE MODIFICATIONS OF METALS BY ION BEAMS, BEIJING, CHINA, 19-24 SEPT. 1999, vol. 128-129, pages 280-285, XP000997583 Surface and Coatings Technology, June-July 2000, Elsevier, Switzerland ISSN: 0257-8972
- DATABASE INSPEC [en ligne] INSTITUTE OF ELECTRICAL ENGINEERS, STEVENAGE, GB; LEE F J ET AL: "Preparation of low refractive index SiO/sub x/F/sub y/ optical thin films by ion beam assisted deposition" Database accession no. 6023368 XP002165261 & HANKOOK KWANGHAK HOEJI, JUNE 1998, OPT. SOC. KOREA, SOUTH KOREA, vol. 9, no. 3, pages 162-167, ISSN: 1225-6285

## Description

L'invention concerne d'une manière générale un procédé de dépôt sur une surface d'un substrat, en particulier d'une lentille ophtalmique, d'une couche de silice dopée au fluor (SiOₓF_{y}).

Les couches minces à base de silice (SiO₂) sont largement utilisées en optique et plus particulièrement dans le domaine de l'optique ophtalmique. De telles couches minces à base de silice sont notamment utilisées dans les revêtements anti-reflets. Ces revêtements anti-reflets sont classiquement constitués d'un empilement multi-couches de matériaux inorganiques. Ces empilements anti-reflets multi-couches compostent généralement une ou plusieurs couche(s) ayant un bas indice de réfraction dans le domaine spectral visible. Classiquement, ces couches de bas indice de réfraction sont constituées par une couche mince à base de silice.

Les techniques de dépôt de telles couches minces à base de silice sont les plus diverses, mais le dépôt par évaporation sous vide est une des techniques les plus largement répandues. Ces couches minces à base de SiO₂ présentent des propriétés mécaniques tout à fait satisfaisantes et des indices de réfraction généralement de l'ordre de 1,48, pour une longueur d'onde voisine de 630 nm.

Cependant, afin de pouvoir, d'une part, améliorer les performances optiques de l'empilement anti-reflets et réaliser de nouveaux systèmes d'empilement anti-reflets, il serait souhaitable de pouvoir abaisser l'indice de réfraction de cette couche bas indice tout en conservant ses propriétés mécaniques satisfaisantes.

Pour résoudre ce problème technique, on a déjà proposé de réaliser des couches de silice (SiO₂) poreuses, c'est-à-dire dans laquelle on a emprisonné de l'air.

Malheureusement, outre des techniques de fabrication complexes, les couches ainsi obtenues présentent des propriétés mécaniques non satisfaisantes et dégradées par rapport à une couche mince de silice classique.

Par ailleurs, il est connu d'utiliser des couches minces de silice dopée au fluor dans d'autres domaines techniques, en particulier dans le domaine de la microélectronique.

Les couches obtenues le sont par dépôt chimique en phase vapeur assisté par plasma sur des disques pour semi-conducteurs.

Cette technique induit un échauffement de substrat qui est porté à des températures élevées, incompatibles avec le traitement de verres organiques ophtalmiques.

De plus, ces couches posent des problèmes de stabilité. La demande de brevet EP-0.957.017 rend compte de problèmes de diffusion de fluor à l'extérieur de la couche de silice dopée au fluor, ce qui entraîne des problèmes d'adhérence.

Le dépôt d'une couche de silice est proposée pour empêcher cette diffusion sans toutefois donner totalement satisfaction.

L'article « Characteristics of SiOₓF_{y} Thin Films Prepared by Ion Beam Assisted Deposition » (Caractéristiques des films minces SiOₓF_{y} préparés par dépôt assisté par faisceau d'ions) », F.J. Lee and C.K. Hwangbo décrit des films minces en oxyde de silicium dopés au fluor (SiOₓF_{y}). L'article décrit en particulier le dépôt de minces films de SiOₓF_{y} d'épaisseur environ 600 nm sur des substrats de verre et de silicium. La pression du vide de base est de 1,2 x 10⁻⁴ Pa et la température du substrat est d'environ 150°C. Le silicium est évaporé au moyen d'un faisceau d'électrons en présence d'oxygène dans la chambre et le dépôt d'oxyde de silicium est bombardé pendant sa formation par un faisceau d'ions polyfluorocarbonés formé au moyen d'un canon à ions à partir de gaz CF₄.

Les minces films SiOₓF_{y} obtenus ont des indices de réfraction variant de 1,394 à 1,462 et peuvent être utilisés comme films optiques.

Toutefois, les couches de SiOₓF_{y} obtenues par le procédé de l'article ci-dessus présentent l'inconvénient de se charger en eau au cours du temps et d'avoir un indice de réfraction instable qui s'accroît au cours du temps.

La présente invention a donc pour objet un procédé de dépôt sur une surface d'un substrat d'une couche de silice dopée au fluor (SiOₓF_{y}) qui présente un indice de réfraction bas, stable au cours du temps et ayant des propriétés mécaniques au moins comparables aux couches de l'art antérieur.

Selon l'invention, le procédé de dépôt sur une surface d'un substrat d'une couche de silice dopée au fluor (SiOₓF_{y}) comprend :
a) L'évaporation de silicium et/ou d'oxyde de silicium ;
b) Le dépôt de silicium et/ou d'oxyde de silicium évaporé à la surface du substrat pour former sur ladite surface de substrat une couche d'oxyde de silicium ; et
c) Le bombardement, lors de sa formation, de la couche d'oxyde de silicium par un faisceau d'ions positifs issu d'un composé polyfluorocarboné ou d'un mélange de composés polyfluorocarbonés, le procédé étant caractérisé en ce que la couche d'oxyde de silicium est également bombardée, lors de sa formation, par un faisceau d'ions positifs issu d'un gaz rare ou d'un mélange de gaz rares.

Comme indiqué ci-dessus, le dépôt d'oxyde de silicium lors de l'étape b) du procédé de l'invention est obtenu en évaporant du silicium et/ou un oxyde de silicium.

On peut utiliser un oxyde de silicium de formule SiOx avec x<2 ou SiO₂. Lorsqu'on utilise SiOx avec x<2, il est nécessaire que le milieu ambiant renferme de l'oxygène O₂,

Bien entendu, on peut utiliser un mélange SiOx/SiO₂. La silice SiO₂ est préférée dans le cadre de l'invention.

Le composé polyfluorocarboné peut être un composé perfluorocarboné linéaire, ramifié ou cyclique, de préférence linéaire ou cyclique.

Parmi les composés perfluorocarbonés linéaires, on peut citer CF₄, C₂F₆, C₃F₈ et C₄F₁₀ ; parmi les composés perfluorocarbonés cycliques, on peut citer C₃F₆ et C₄F₈ ; le composé perfluorocarboné linéaire préféré est CF₄ et le composé cyclique C₄F₈.

On peut également utiliser un mélange des composés perfluorocarbonés.

Le composé polyfluorocarboné peut être également un hydrogénofluorocarbone, choisi de préférence parmi CHF₃, CH₂F₂, C₂F₄H₂. L'hydrogénofluorocarbone peut être lui aussi linéaire, ramifié ou cyclique.

Bien entendu, on peut utiliser un mélange de composés perfluorocarbonés et d'hydrogénofluorocarbones.

Le gaz rare est préférentiellement choisi parmi le xénon, le krypton et leurs mélanges. Le gaz rare préféré est le xénon.

Lors du dépôt de la couche de silice dopée au fluor, le substrat est généralement à une température inférieure à 150°C, de préférence inférieure ou égale à 120°C et mieux encore de 30°C à 100°C.

Dans une réalisation préférentielle de l'invention, la température du substrat varie de 50 à 90°C.

Le fait que le dépôt selon l'invention peut se faire à une température relativement basse, permet de former des couches minces sur une grande variété de substrats et en particulier des substrats en verre organique, tels que des lentilles ophtalmiques en verre organique.

Généralement, le procédé de l'invention est mis en oeuvre dans une chambre à vide à une pression de 10⁻² à 10⁻³ Pa. Eventuellement, du gaz oxygène peut être introduit dans la chambre à vide lors du dépôt de la couche.

Les couches d'oxyde de silicium dopées au fluor de l'invention ont en général une épaisseur de 10 à 500 nm, de préférence de 80 à 200 nm, et la teneur en fluor des couches est généralement de 6 à 10% atomique.

Le teneur en silicium est généralement de l'ordre de 30% atomique.

Les couches d'oxyde de silicium dopées au fluor obtenues par le procédé de l'invention ont un indice de réfraction n ≤ 1,48, de préférence de 1,42 à 1,45 (pour un rayonnement de longueur d'onde λ = 632,8 nm à 25°C).

La suite de la description se réfère aux figures annexées qui représentent respectivement :
Figure 1, une vue schématique d'un dispositif pour la mise en oeuvre du procédé de l'invention ; et
Figure 2, une vue schématique de dessus du dispositif de la Figure 1.

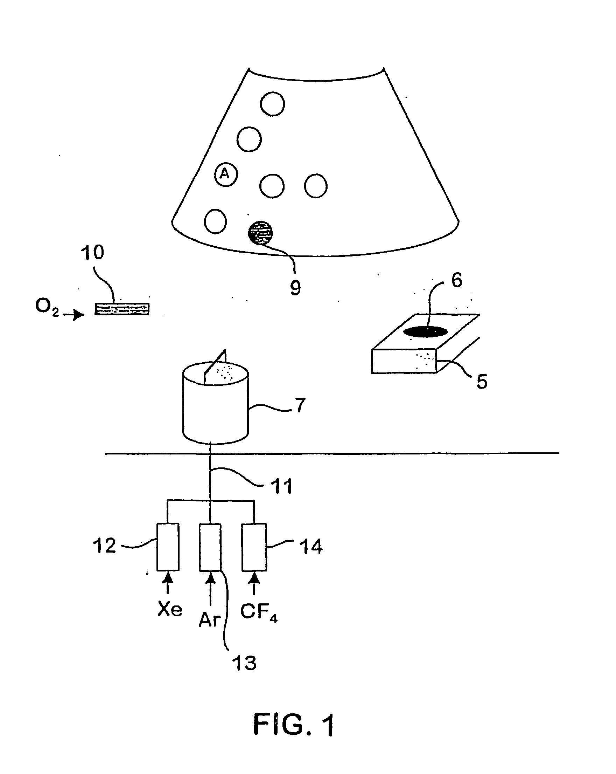

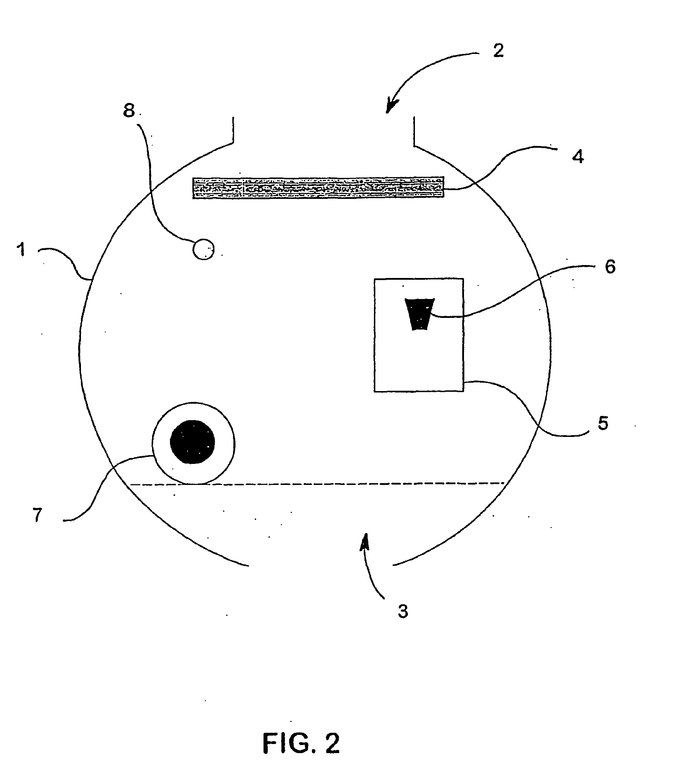

Le dispositif de dépôt assisté par faisceau d'ions de films minces des figures 1 et 2 est un dispositif classique. Ce dispositif comprend une chambre à vide 1 dont une première extrémité 2 est réunie à une ou plusieurs pompes à vide et l'autre extrémité opposée comporte une porte 3. Un piège froid 4 peut être disposé dans la chambre à proximité de l'extrémité 2 reliée aux pompes à vide. A l'intérieur de la chambre 1, se trouve un canon à électrons 5 comportant un creuset 6 destiné à contenir la silice à vaporiser. Les substrats à revêtir A sont disposés sur un support à proximité d'une micro-balance à quartz 9. Une alimentation en gaz oxygène de la chambre 10 peut éventuellement être prévue. La pression dans la chambre peut être mesurée au moyen d'une jauge de pression à cathode chaude 8. La conduite d'alimentation 11 du canon à ions 7 est reliée à trois dispositifs de commande d'alimentation en gaz permettant d'alimenter simultanément ou indépendamment le canon à ions avec les gaz de nature et/ou débits voulus.

Dans le cas présent, la chambre à vide est une chambre Leybold Heraeus capable d'atteindre un vide de base de 5.10⁻⁵ Pa, le canon à ions est un canon MARK II Commonwealth, et le canon à électrons est un canon Leybold ESV.

Pour les dispositifs de commande de l'alimentation en gaz du canon à ions, on utilise un dispositif de commande de débit massique BROOKS pour le gaz argon, lui-même commandé par le dispositif de commande MARK II. Pour l'alimentation en xénon et en composé polyfluorocarboné, on utilise des dispositifs de commande des débits massiques tels que le dispositif de commande multigaz MKS 647 B dans lequel la nature et le débit des gaz peut être programmé.

Le dépôt sur les substrats de la couche de silice dopée au fluor selon l'invention peut être mis en oeuvre de la façon suivante :

La chambre 1 est mise sous un vide 2.10⁻³ Pa (mesuré au moyen de la jauge de pression à cathode chaude 8). Le canon à ions 7 est amorcé avec du gaz argon, puis on introduit du gaz CF₄ et du xénon aux débits choisis et le flux d'argon est interrompu. Les grains de silice (SiO₂) disposés dans le creuset 6 sont préchauffés par le canon à faisceau d'électrons. Lorsque du gaz d'oxygène est utilisé, il est introduit dans la chambre avec un débit réglé. A la fois, le canon à faisceau d'électrons et le canon à ions sont équipés d'un obturateur, et les deux obturateurs du canon à faisceau d'électrons et du canon d'ions sont ouverts simultanément. L'épaisseur du dépôt est réglée par la microbalance à quartz 9 à proximité des substrats échantillons. Lorsque l'épaisseur voulue des films est obtenue, les deux obturateurs sont fermés, les canons à faisceau d'électrons et à ions sont coupés, l'alimentation des différents gaz arrêtée, et le vide de la chambre rompu. Les substrats échantillons revêtus de la couche de silice dopée au fluor selon l'invention sont alors récupérés.

Les exemples suivants illustrent la présente invention.

En procédant comme décrit précédemment, on a revêtu des échantillons plans de silicium avec des couches de silice dopées au fluor. L'indice de réfraction à la longueur d'onde λ, = 632,8 nm et à 25°C des couches de silice dopées au fluor formées a été mesuré à différents moments après la formation des couches. On a également déterminé, par spectrométrie infrarouge, l'absorption d'eau par les couches formées à différents moments après la réalisation des couches, cette absorption étant caractéristique de l'évolution de la couche au cours du temps. Les conditions de dépôt des couches de silice dopées au fluor sont indiquées au Tableau I, cependant que les propriétés des couches obtenues, en particulier l'indice de réfraction et la détection de présence d'eau par spectrométrie infrarouge et l'épaisseur des couches obtenues, sont indiquées dans le Tableau II.

**TABLEAU I**

| Conditions de dépôt | | | | | | | | | |
|---|---|---|---|---|---|---|---|---|---|
| Exemple N° | Vitesse de dépôt (nm/s) | Courant d'anode du canon à ions (A) | Tension d'anode de canon à ions (V) | Composé polyfluorocarboné | Débit composé polyfluorocarboné (cm³/minute) | Débit Xe (cm³/minute) | Débit O₂ (cm³/minute) | Pression de la chambre (Pa) (1) | Température du substrat (°C) |
| Comparatif C1 | 0,51 | 0,53 | 160 | CF₄ | 2,3 | - | - | 4.10⁻³ | 70°C⁽²⁾ |
| Comparatif C2 | 0,18 | 0,3 | 100 | CF₄ | 1,8 | - | - | 5,3.10⁻³ | 180°C⁽³⁾ |
| 1 | 0,75 | 4 | 150 | CF₄ | 2,5 | 2,9 | 4 | 1,8.10⁻² | 70°C⁽²⁾ |
| 2 | 0,75 | 0,5 | 100 | CF₄ | 1,5 | 0,5 | 4 | 7,9.10⁻³ | 70°C⁽²⁾ |
| 3 | 0,5 | 4 | 150 | C₄F₈ | 1 | 2,7 | 15 | 2,4.10⁻² | 70°C⁽²⁾ |

| | | | | | | | | | |
|---|---|---|---|---|---|---|---|---|---|
| (1) Mesurée au cours du dépôt (2) Température obtenue par échauffement du substrat sous l'effet du canon à ions (3) Température maintenue pendant tout le dépôt par un dispositif de chauffage. | | | | | | | | | |

**TABLEAU II**

| Propriétés des couches de SiOxFy | | | | | | | | | |
|---|---|---|---|---|---|---|---|---|---|
| Exemple N° | Epaisseur (nm) | Indice de réfraction à λ = 632,8 nm | | | | | Présence d'eau (IR) | | |
| | | Après 1 heure | Après 24 heures | Après 2 jours | Après 2 semaines | Après 2 mois | Après 1 heure | Après 2 jours | Après 2 semaines |
| Comparatif C1 | 125 | 1,415 | - | 1,465 | - | - | Non | Oui | - |
| Comparaatif C2 | 110 | 1,400 | 1,448 | - | - | - | - | - | - |
| 1 | 190 | 1,429 | - | - | 1,432 | 1,435 | Non | Non | Non |
| 2 | 180 | 1,444 | - | - | 1,449 | 1,450 | Non | Non | Non |
| 3 | 190 | 1,434 | - | - | 1,437 | - | Non | non | Non |

Les résultats du Tableau II montrent que le bombardement avec un faisceau d'ions issu à la fois d'un composé polyfluorocarboné et d'un gaz rare, dans ce cas le xénon, permet d'obtenir une stabilisation particulièrement notable de l'indice de réfraction au cours du temps. En effet, l'indice de réfraction des couches des exemples comparatifs C1, C2 a augmenté de 3,5% après deux jours et de 3,4% après 24 heures, respectivement, alors que l'indice de réfraction des couches des exemples 1 à 3 obtenues par le procédé de l'invention ne présente qu'une augmentation inférieure à 0,35% après deux semaines, et inférieure à 0,42% après 2 mois.

## Revendications

1. Procédé de dépôt sur une surface d'un substrat d'une couche de silice dopée au fluor (SiOₓF_{y}) comprenant :
- (a) l'évaporation de silicium et/ou d'oxyde de silicium ;
- (b) le dépôt de silicium et/ou d'oxyde de silicium évaporé à la surface du substrat pour former sur ladite surface de substrat une couche d'oxyde de silicium ce dépôt se faisant en présence d'oxygène lorsqu'on utilise du silicium ou un oxyde de silicium SiOx avec x < 2 ; et
- (c) le bombardement, lors de sa formation, de la couche d'oxyde de silicium par un faisceau d'ions positifs issu d'un composé polyfluorocarboné ou d'un mélange de composés polyfluorocarbonés ;
**caractérisé en ce que** la couche d'oxyde de silicium est également bombardée, lors de sa formation, par un faisceau d'ions positifs issu d'un gaz rare ou d'un mélange de gaz rares.

2. Procédé selon la revendication 1, **caractérisé en ce que** le composé polyfluorocarboné est un composé perfluorocarboné linéaire ou cyclique.

3. Procédé selon la revendication 2, **caractérisé en ce que** le composé perfluorocarboné linéaire est choisi parmi les composés CF₄, C₂F₆, C₃F₈ et les composés perfluorocarbonés cycliques sont choisis parmi les composés C₃F₆ et C₄F₈, de préférence C₄F₈.

4. Procédé selon la revendication 1, **caractérisé en ce que** le composé polyfluorocarboné est un hydrogénofluorocarbone.

5. Procédé selon la revendication 4, **caractérisé en ce que** l'hydrogénofluorocarbone est choisi parmi CHF₃, CH₂F₂, C₂F₄H₂.

6. Procédé selon l'une quelconque des revendications précédentes, **caractérisé en ce que** le gaz rare est choisi parmi le xénon et le krypton, de préférence le xénon.

7. Procédé selon l'une quelconque des revendications précédentes, **caractérisé en ce que** lors du dépôt de l'oxyde de silicium et du bombardement, le substrat est à une température inférieure à 150°C, de préférence inférieure à 120°C.

8. Procédé selon la revendication 5, **caractérisé en ce que** le substrat est à une température de 30°C à 100°C, de préférence de 50°C à 90°C.

9. Procédé selon l'une quelconque des revendications précédentes, **caractérisé en ce qu'**il est mis en oeuvre dans une chambre à vide à une pression de 10⁻² à 10⁻³ Pa.

10. Procédé selon l'une quelconque des revendications précédentes, **caractérisé en ce que** du gaz oxygène est introduit dans la chambre au cours du dépôt.

11. Procédé selon l'une quelconque des revendications précédentes, **caractérisé en ce que** la couche d'oxyde de silicium dopée au fluor formée à une épaisseur de 10 à 500 nm, de préférence de 80 à 200 nm.

12. Procédé selon l'une quelconque des revendications précédentes, **caractérisé en ce que** la teneur en fluor de la couche d'oxyde de silicium dopée au fluor est de 6% à 10% atomique.

13. Procédé selon l'une quelconque des revendications précédentes, **caractérisé en ce que** la couche d'oxyde de silicium a un indice de réfraction n à une longueur d'ondes de 632,8 nm et à 25°C inférieur à 1,48 et de préférence de 1,42 à 1,45.

14. Procédé selon l'une quelconque des revendications précédentes **caractérisé en ce que** le substrat est une lentille ophtalmique.

15. Procédé selon l'une quelconque des revendications 1 à 13, **caractérisé en ce que** le substrat est un échantillon plan de silicium.

## Claims

1. Process for depositing on a surface of a substrate a fluorine-doped silica layer (SiOxFy) comprising:
- (a) the evaporation of silicon and/or silicon oxide;
- (b) the deposition of silicon and/or silicon oxide evaporated on the surface of the substrate in order to form on said substrate surface a silicon oxide layer, said deposition being carried out in the presence of oxygen when silicon or silicon oxide SiOx with x<2 are used ; and
- (c) the bombardment of the silicon oxide layer, during its formation, by a beam of positive ions derived from a polyfluorocarbonated compound or of a mixture of polyfluorocarbonated compounds;
**characterized in that** the silicon oxide layer is also bombarded, during its formation, by a beam of positive ions derived from a rare gas or a mixture of rare gases.

2. Process according to claim 1, **characterized in that** the polyfluorocarbonated compound is a linear or cyclic perfluorocarbonated compound.

3. Process according to claim 2, **characterized in that** the linear perfluorocarbonated compound is selected from the compounds CF₄, C₂F₆, C₃F₈ and **in that** the cyclic perfluorocarbonated compounds are selected from the compounds C₃F₆ and C₄F₈, and preferably C₄F₈.

4. Process according to claim 1, **characterized in that** the polyfluorocarbonated compound is a hydrogenofluorocarbon.

5. Process according to claim 4, **characterized in that** the hydrogenofluorocarbon is selected from CHF₃, CH₂F₂, C₂F₄H₂.

6. Process according to any one of the preceding claims, **characterized in that** the rare gas is selected from xenon and krypton, and is preferably xenon.

7. Process according to any one of the preceding claims, **characterized in that** during the deposition of the silicon oxide and bombardment, the substrate is at a temperature lower than 150°C, and preferably lower than 120°C.

8. Process according to claim 5, **characterized in that** the substrate is at a temperature between 30°C and 100°C, and preferably between 50°C and 90°C.

9. Process according to any one of the preceding claims, **characterized in that** it is carried out in a vacuum chamber at a pressure of 10⁻² to 10⁻³ Pa.

10. Process according to any one of the preceding claims, **characterized in that** oxygen gas is introduced into the chamber during the deposition.

11. Process according to any one of the preceding claims, **characterized in that** the fluorine-doped silicon oxide layer formed has a thickness of 10 to 500 nm, and preferably of 80 to 200 nm.

12. Process according to any one of the preceding claims, **characterized in that** the atomic fluorine content of the fluorine-doped silicon oxide layer is from 6% to 10%.

13. Process according to any one of the preceding claims, **characterized in that** the silicon oxide layer has a refractive index, n, at a wavelength of 632.8 nm and at 25°C of less than 1.48 and preferably ranging from 1.42 to 1.45.

14. Process according to any one of the preceding claims **characterized in that** the substrate is an ophthalmic lens.

15. Process according to any one of the claims 1 to 13, **characterized in that** the substrate is a flat silicon sample.

## Patentansprüche

1. Verfahren zum Fällen einer fluordotierten Siliziumdioxidschicht (SiOₓF_{y}) an einer Oberfläche eines Substrats umfassend:
a. die Verdampfung von Silizium und/oder von Siliziumoxid;
b. das Fällen von verdampftem Silizium und/oder Siliziumoxid an der Oberfläche des Substrats, um eine Siliziumoxidschicht an besagter Substratoberfläche zu bilden, wobei dieses Fällen in Anwesenheit von Sauerstoff vor sich geht, insoweit Silizium oder eines Siliziumoxids SiOx mit x < 2 verwendet wird; und
c. das Beschießen der Siliziumoxidschicht, während ihrer Bildung, mit einem Strahl positiver Ionen, die von einer Polyfluorkhlenstoffverbindung oder einem Gemisch aus Polyfluorkohlenstoffverbindungen herrühren;
**dadurch gekennzeichnet, dass** die Siliziumoxidschicht, während ihrer Bildung, ebenfalls mit einem Strahl positiver Ionen, die aus einem Edelgas oder einem Gemisch an Edelgasen herrühren beschossen wird.

2. Verfahren nach Anspruch 1, **dadurch gekennzeichnet, dass** die Polyfluorkohlenstoffverbindung eine lineare oder zyklische Perfluorkohlenstoffverbindung ist.

3. Verfahren nach Anspruch 2, **dadurch gekennzeichnet, dass** die lineare Perfluorkohlenstoffverbindung ausgewählt ist unter den Verbindungen CF₄, C₂F₆, C₃F₈ und die zyklischen ausgewählt sind unter den Verbindungen C₃F₆ und C₄F₈, vorzugsweise C₄F₈.

4. Verfahren nach Anspruch 1, **dadurch gekennzeichnet, dass** die Polyfluorkohlenstoffverbindung ein Fluorkohlenwasserstoff ist.

5. Verfahren nach Anspruch 4, **dadurch gekennzeichnet, dass** der Fluorkohlenwasserstoff ausgewählt ist unter CHF₃, CH₂F₂, C₂F₄H₂.

6. Verfahren nach einem der vorhergehenden Ansprüche, **dadurch gekennzeichnet, dass** das Edelgas ausgewählt ist unter Xenon und Krypton, vorzugsweise Xenon.

7. Verfahren nach einem der vorhergehenden Ansprüche, **dadurch gekennzeichnet, dass** während dem Fällen oder Niederschlagen des Siliziumoxids und des Beschießens das Substrat eine Temperatur von unter 150°C, vorzugsweise unter 1200°C, aufweist.

8. Verfahren nach Anspruch 5, **dadurch gekennzeichnet, dass** das Substrat eine Temperatur von 30°C bis 100°C, vorzugsweise von 50°C bis 90°C, aufweist.

9. Verfahren nach einem der vorhergehenden Ansprüche, **dadurch gekennzeichnet, dass** es in einer Vakuumkammer bei einem Druck von 10⁻² bis 10⁻³ Pa durchgeführt wird.

10. Verfahren nach einem der vorhergehenden Ansprüche, **dadurch gekennzeichnet, dass** während dem Fällen Sauerstoffgas in die Kammer eingeleitet wird.

11. Verfahren nach einem der vorhergehenden Ansprüche, **dadurch gekennzeichnet, dass** die gebildete fluordotierte Siliziumoxidschicht eine Dicke von 10 bis 500 nm, vorzugsweise von 80 bis 200 nm, aufweist.

12. Verfahren nach einem der vorhergehenden Ansprüche, **dadurch gekennzeichnet, dass** der Fluorgehalt der fluordotierten Siliziumoxidschicht von 6 bis 10 Atomprozent ist.

13. Verfahren nach einem der vorhergehenden Ansprüche, **dadurch gekennzeichnet, dass** die Siliziumoxidschicht bei einer Wellenlänge von 632,8 nm und bei 25°C einen Brecheungsindex n von unter 1,48 und vorzugsweise von 1,42 bis 1,45 aufweist.

14. Verfahren nach einem der vorhergehenden Ansprüche, **dadurch gekennzeichnet, dass** das Substrat eine ophthalmische Linse ist.

15. Verfahren nach einem der Ansprüche 1 bis 13, **dadurch gekennzeichnet, dass** das Substrat eine plane Siliziumprobe ist.
